Europäisches Patentamt

European Patent Office

Office européen des brevets

(19)

(11) **EP 1 241 282 B1**

(12) **EUROPEAN PATENT SPECIFICATION**

(45) Date of publication and mention
of the grant of the patent:
**19.10.2005 Bulletin 2005/42**

(51) Int Cl.7: **C30B 15/00**, C30B 15/34

(21) Application number: **02005528.1**

(22) Date of filing: **11.03.2002**

(54) **Method of and apparatus for pulling up crystal**

Verfahren und Vorrichtung zur Ziehung eines Kristalles

Procédé et appareillage pour le tirage d'un cristal

(84) Designated Contracting States:
**DE ES FR GB IT NL**

(30) Priority: **14.03.2001 JP 2001072281**

(43) Date of publication of application:
**18.09.2002 Bulletin 2002/38**

(73) Proprietor: **EBARA CORPORATION**
**Ohta-ku, Tokyo (JP)**

(72) Inventors:
 • **Terao, Kenji**
  **Tokyo (JP)**
 • **Isozaki, Hideyuki**
  **Tokyo (JP)**
 • **Yamaguchi, Yasuyoshi**
  **Tokyo (JP)**

(74) Representative: **Wagner, Karl H. et al**
**WAGNER & GEYER**
**Patentanwälte**
**Gewürzmühlstrasse 5**
**80538 München (DE)**

(56) References cited:
 **WO-A-00/66818        US-A- 4 267 010**
 **US-A- 4 267 153**

 • **PATENT ABSTRACTS OF JAPAN vol. 007, no.
   135 (C-170), 11 June 1983 (1983-06-11) & JP 58
   049688 A (TOKYO SHIBAURA DENKI KK), 23
   March 1983 (1983-03-23)**
 • **PATENT ABSTRACTS OF JAPAN vol. 007, no.
   273 (C-198), 6 December 1983 (1983-12-06) & JP
   58 151394 A (TOKYO SHIBAURA DENKI KK), 8
   September 1983 (1983-09-08)**

**Description**

BACKGROUND OF THE INVENTION

Field of the Invention:

The present invention relates to a method of and an apparatus for pulling up a strip of semiconductor crystal (web crystal) continuously from a crucible with a pair of endless belts.

Description of the Related Art:

Large-area monocrystalline or polycrystalline silicon crystal substrates in the form of strips are produced for use in solar cells or the like. A monocrystalline or polycrystalline silicon crystal substrate is produced by pulling up a seed crystal along a given crystal axis from a crucible which contains a molten silicon material adjusted to a certain temperature, thus growing a strip of crystal continuously from the molten silicon material. When the strip of crystal is sandwiched between and pulled up by a pair of endless belts, it is continuously produced as an elongate strip of crystal. The elongate strip of crystal is flexible because it is as thin as about 100 μm. After the elongate strip of crystal is gripped and pulled up vertically, it is flexibly bent along an arcuately curved surface having a large radius of curvature, and then introduced into a cutting apparatus. In the cutting apparatus, the elongate strip of crystal is cut into a rectangular sheet of monocrystalline or polycrystalline silicon crystal.

When the strip of crystal is sandwiched between and pulled up by the endless belts continuously from the crucible, the crystal may not be grown exactly upwardly, but may be laterally displaced. Specifically, while the strip of crystal being sandwiched between the endless belts and pulled up continuously from the crucible, the crystal may be displaced out of alignment with the vertical central axis of the endless belts, and may be grown in a direction away from the endless belts. If the crystal is thus displaced, it cannot be fed smoothly into the downstream cutting apparatus. If the crystal is so displaced that it is disengaged from the endless belts, it cannot be pulled up smoothly from the crucible.

When the crystal as it is continuously pulled up is grown out of alignment with the vertical central axis of the endless belts, it has been customary for the worker to manually correct the crystal out of the positional displacement. Specifically, the worker visually checks the crystal as it is pulled up from the crucible and manually adjusts the position where the crystal is pulled up by the endless belts, so that the crystal will be pulled up substantially along the vertical central axis of the endless belts. The manual adjusting process requires the worker to be highly skilled because no excessive shocks are to be imposed on the crystal being pulled up, and is quite tedious and time-consuming as it needs to be accompanied by the visual checking process. Furthermore, the crystal starts growing from the linear seed crystal and becomes progressively wider into the strip of crystal having a desired width. While the crystal is thus growing in the strip of crystal, the position of the crystal with respect to the endless belts needs to be adjusted at all times, and hence the process of pulling up the crystal is laborious.

Patent Abstracts of Japan vol. 007, no. 135 (C-170), 11 June 1983 (1983-06-11) & JP 58 049688 A (Tokyo Shibaura Denki KK), 23 March 1983 (1983-03-23) disclose a device for pulling up a crystal more uniformly. The device comprises two pairs of conveyer rollers to support and sandwich therebetween a ribbon-like crystal. A drive motor provides for the rotation of the conveyer rollers by means of drive and connection belts cooperating with a drive pulley. The device for pulling up the crystal provides for an automatic adjustment of the fluctuations in the thickness of the crystal so that the constant presence of an operator is not required.

In accordance with the present invention, an apparatus for pulling up a strip of semiconductor crystal continuously from a crucible as set forth in claim 1 is provided. Preferred embodiments of the invention are disclosed in the dependent claims.

SUMMARY OF THE INVENTION

It is therefore an object of the present invention to provide a method of and an apparatus for pulling up a strip of crystal stably and continuously from a crucible with a pair of endless belts without the need for a tedious and time-consuming manual process.

According to the present invention, there is provided an apparatus for pulling up a strip of semiconductor crystal continuously from a crucible, comprising a position control device for automatically adjusting a transverse position of the strip of semiconductor crystal, the position control device being disposed in a path for pulling up the strip of semiconductor crystal from the crucible.

With the above arrangement, even when the strip of semiconductor crystal is displaced from the direction of growth thereof, the position control device operates to keep the center of the strip of semiconductor crystal in substantial alignment with the central axis of the endless belts of a pull-up mechanism for thereby allowing the strip of semiconductor crystal to be pulled up stably.

The position control device comprises a pair of blocks disposed one on each side of the path transversely of the strip of semiconductor crystal and movable transversely of the strip of semiconductor crystal, and a pair of position sensors mounted respectively on the blocks for detecting respective edges of the strip of semiconductor crystal, the blocks having respective side faces for adjusting a direction in which the strip of semiconductor crystal is pulled up, by contacting the respective edges of the strip of semiconductor crystal.

An edge of the strip of semiconductor crystal is detected by a corresponding one of the position sensors at each time interval or pulled-up length, and the corresponding side face is fixed in a position which is spaced about 0.5 mm, for example, from the detected edge. When the strip of semiconductor crystal contacts the side edge, it is restricted against transverse movement. As a result, the direction in which the strip of semiconductor crystal is grown is corrected, and hence the strip of semiconductor crystal is pulled up substantially along the central axis of the endless belts.

The apparatus further comprises a control mechanism for simultaneously starting to move the blocks from respective home positions thereof, and stopping the blocks against movement when the position sensor on either one of the blocks detects a corresponding edge of the strip of semiconductor crystal.

The blocks are returned to their home positions, and then simultaneously started to move inwardly toward the strip of semiconductor crystal. When the position sensor on either one of the blocks detects the corresponding edge of the strip of semiconductor crystal, the blocks are stopped against movement. Even if the width of the strip of semiconductor crystal increases gradually or the direction of movement thereof is inverted, the side face of the block can be positioned near the corresponding edge of the strip of semiconductor crystal. If the strip of semiconductor crystal grows in a displaced direction, then an edge of the strip of semiconductor crystal is brought into sliding contact with the corresponding side face of the block, and restricted against transverse movement, with the result that the direction of growth of the strip of semiconductor crystal is corrected. Since the blocks are fixed in position at periodic intervals, the direction of growth of the strip of semiconductor crystal can be corrected stably even when the width of the strip of semiconductor crystal varies depending on the pulled-up length thereof.

According to the present invention, there is also provided a method of pulling up a strip of semiconductor crystal continuously, comprising; detecting an edge of the strip of semiconductor crystal while the strip of semiconductor crystal is being pulled up, and fixing a side face near the detected edge for sliding contact with the detected edge to restrict the strip of semiconductor crystal against transverse movement.

In the above method, the edge of the strip of semiconductor crystal is detected and the side face is positionally adjusted intermittently depending on a change in the transverse dimension of the strip of semiconductor crystal.

The above and other objects, features, and advantages of the present invention will become apparent from the following description when taken in conjunction with the accompanying drawings which illustrate preferred embodiments of the present invention by way of example.

BRIEF DESCRIPTION OF THE DRAWINGS

FIG. 1A is a front elevational view of a crystal pulling-up apparatus according to the present invention, showing a phase of operation thereof in which a seed crystal is pulled up;

FIG. 1B is a side elevational view of the crystal pulling-up apparatus, showing a phase of operation thereof in which a strip of crystal is continuously pulled up by a pair of endless belts;

FIG. 2A is a front elevational view of a position control device in the crystal pulling-up apparatus, for automatically adjusting the transverse position of the strip of crystal;

FIG. 2B is a side elevational view of the position control device;

FIG. 3A is a plan view of the position control device, showing a mode of operation thereof detecting an edge of the strip of crystal which is illustrated in horizontal cross section;

FIG. 3B is a front elevational view of the position control device, showing the mode of operation thereof detecting the edge of the strip of crystal which is illustrated in front elevation;

FIG. 4A is a front elevational view of the position control device, showing a mode of operation thereof slidingly contacting an edge of the strip of crystal which is illustrated in horizontal cross section;

FIG. 4B is a front elevational view of the position control device, showing the mode of operation thereof slidingly contacting the edge of the strip of crystal which is illustrated in front elevation;

FIG. 5 is a diagram showing, by way of example, how a crystal being pulled up spreads transversely;

FIG. 6 is a diagram showing measured central positions of a crystal and measured angles at which the crystal is tilted, when the crystal is positionally controlled by the position control device; and

FIG. 7 is a diagram showing measured central positions of a crystal and measured angles at which the crystal is tilted, when the crystal is not positionally controlled by the position control device.

DETAILED DESCRIPTION OF THE PREFERRED EMBODIMENTS

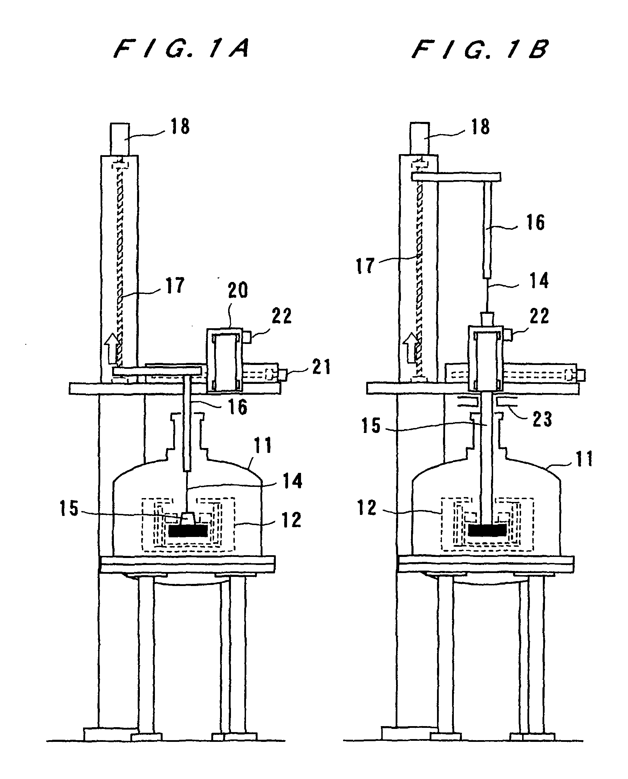

FIGS. 1A and 1B show a crystal pulling-up apparatus according to the present invention. FIG. 1A shows a stage of operation thereof in which a seed crystal is pulled up, and FIG. 1B shows a stage of operation thereof in which a strip of crystal is continuously pulled up by a pair of endless belts.

As shown in FIGS. 1A and 1B, the crystal pulling-up apparatus includes a crystal growth furnace 11 having a crucible 12 disposed centrally therein. The crucible 12 holds a molten silicon therein at a predetermined temperature. When a seed crystal 14 is immersed in the molten silicon in the crucible 12 and then pulled up, a strip of crystal 15 joined to the seed crystal 14 is grown and pulled up from the molten silicon. By orienting the crystal axis of the seed crystal 14 in a certain direction, the strip of crystal 15 is pulled up as a sheet of monocrystalline or polycrystalline silicon crystal. The seed crystal 14 is held by a seed crystal holder 16 which extends vertically and pulled up in the vertical direction by a vertical straight pull-up mechanism 17 connected to the seed crystal holder 16 when a drive motor 18 coupled to the vertical straight pull-up mechanism 17 is energized.

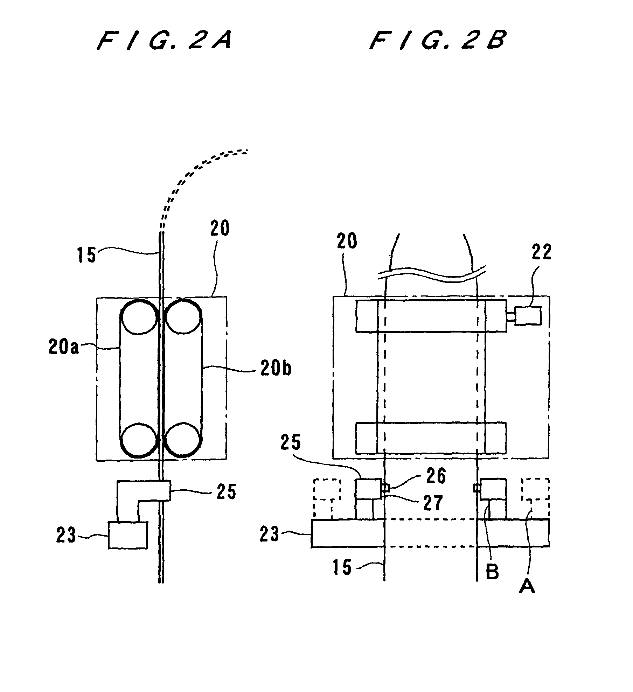

An endless belt pull-up mechanism 20 having a pair of endless belts 20a, 20b (see FIG. 2A) actuatable by a motor 221 is horizontally movably disposed above the crystal growth furnace 11. When the seed crystal 14 is pulled up until it reaches a position higher than the endless belt pull-up mechanism 20, the upper end of the strip of crystal 15 joined to the lower end of the seed crystal 14 also reaches the position higher than the endless belt pull-up mechanism 20. Then, the endless belt pull-up mechanism 20 is horizontally moved by the motor 21 to a position for sandwiching the strip of crystal 15. Then, the endless belts 20a, 20b of the endless belt pull-up mechanism 20 sandwich the strip of crystal 15, and the seed crystal 14 is severed off the strip of crystal 15. Thereafter, a drive motor 22 of the endless belt pull-up mechanism 20 is energized to cause the endless belts 22a, 22b to pull up the sandwiched strip of crystal 15 continuously. The strip of crystal 15 has a width in the range from 70 to 80 mm, for example, and a thickness of 150 μm, which makes the strip of crystal 15 flexible. The strip of crystal 15 is then delivered along an arcuate path to a cutting apparatus. In the cutting apparatus, the strip of crystal 15 is cut into a rectangular sheet of monocrystalline or polycrystalline silicon crystal. The rectangular sheet of monocrystalline or polycrystalline silicon crystal thus produced will be mounted on a solar cell panel or the like after some materials are diffused into the rectangular sheet of monocrystalline or polycrystalline silicon crystal.

The crystal pulling-up apparatus has a position control device 23 disposed below the endless belt pull-up mechanism 20, for positionally adjusting the strip of crystal 15 so that the strip of crystal 15 will be pulled up in a correct position. The position control device 23 restricts the strip of crystal 15 in its horizontal or transverse direction by slidingly contacting an edge of the strip of crystal 15, for thereby limiting the direction of growth of the strip of crystal 15 in order to cause the crystal to be pulled up through the center of the endless belts. While the strip of crystal 15 is being continuously pulled up, the strip of crystal 15 is guided by the position control device 23 so as to be pulled up through the center of the endless belts. Therefore, even when the strip of crystal 15 is pulled up for a continuous length of several hundred meters, the strip of crystal 15 remains positioned and is stably pulled up through the center of the endless belts. For continuously pulling up the strip of crystal 15, it is necessary to charge a new silicon material into the crucible 12. By charging the new silicon material and pulling up the strip of crystal 15 at balanced rates, it is possible to continuously pull up the strip of crystal 15 while keeping the molten silicon material at a constant level in the crucible 12.

Structural details and operation of the position control device 23 will be described below with reference to FIGS. 2A through 4B. The position control device 23 has a pair of blocks 25 disposed immediately below the endless belt pull-up mechanism 20 and spaced horizontally from each other, for adjusting the horizontal position of the strip of crystal 15 as it is pulled up. The blocks 25 have respective sensors 26 for detecting respective edges of the strip of crystal 15 and respective side faces 27 horizontally facing each other for slidingly contacting the respective edges of the strip of crystal 15. The sensors 26 are mounted respectively on the side faces 27. The position control device 23 also includes a drive mechanism (not shown) for moving the blocks 25 toward and away from each other. In operation, the blocks 25 are moved by the drive mechanism inwardly toward each other at equal speeds from respective home positions which are sufficiently spaced from the respective edges of the strip of crystal 15. When either one of the edges of the strip of crystal 15 is detected by the corresponding sensor 26, the blocks 25 are stopped and fixed in position. The position control device 23 also has a function to return the blocks 25 to their home positions at a suitable time interval in response to a signal, move the blocks 25 inwardly toward each other, and then stop the blocks 25 at a position where either one of the edges of the strip of crystal 15 is detected by the corresponding sensor 26.

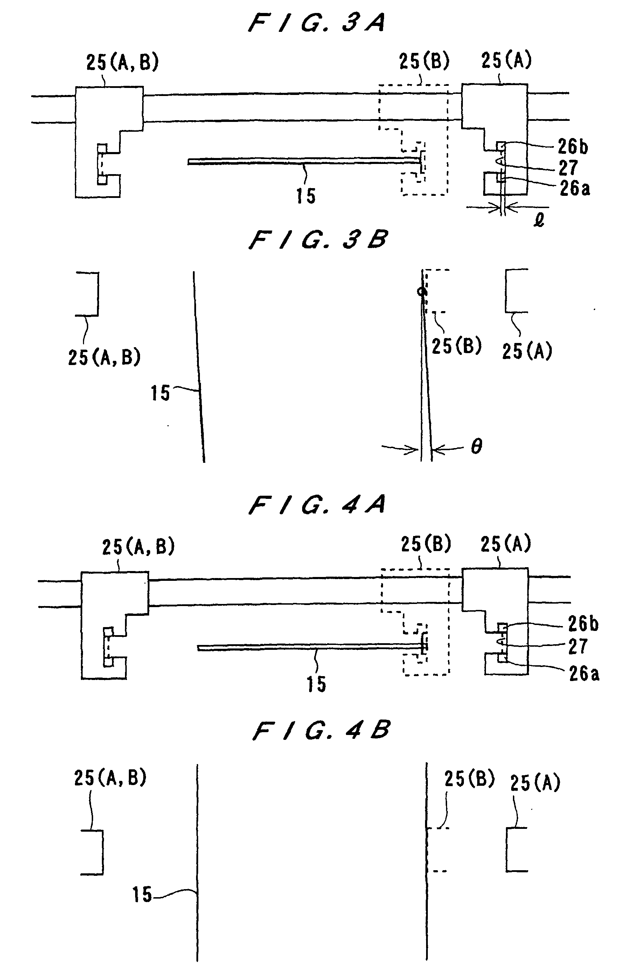

As described above, the blocks 25 are horizontally movable and their fixed positions are adjustable depending on the width of the strip of crystal 15. Specifically, the strip of crystal 15 has a certain width immediately after it starts being pulled up by the seed crystal 14 and a different width after it has been pulled up for a length in the range from 100 meters to several hundred meters. More specifically, when the seed crystal 14 begins to be pulled up, the strip of crystal 15 has a width in the range from about 40 to 50 mm. As the strip of crystal 15 is progressively pulled up, the strip of crystal 15 progressively widens. When the strip of crystal 15 is pulled up for about 100 meters, the strip of crystal 15 has a constant width ranging from about 70 to 80 mm. The home positions A indicated by the solid lines and the fixed positions B indicated by the dotted lines are determined depending on the width of the strip of crystal 15 to be positionally adjusted. Each of the sensors 26 on the blocks 25 is an optical fiber sensor, for example, comprising a light-emitting element 26a and a light-detecting element 26b (see FIGS. 3A and 4A) which are horizontally spaced from each other in confronting relation to each other. When an edge of the strip of crystal 15 is placed between the light-emitting element 26a and the light-detecting element 26b, it blocks a beam of light emitted from light-emitting element 26a. Since no beam of light is detected by the light-detecting element 26b at this time, the optical fiber sensor 26 detects the edge of the strip of crystal 15. The side face 27 of each of the optical fiber sensors 26 is spaced outwardly from the optical axis of the optical fiber sensors 26 by a small distance 1 of about 0.5 mm, for example (see FIG. 3A). While the strip of crystal 15 is being pulled up, when the block 25 is moved from the home position A toward the edge of the strip of crystal 15, the optical fiber sensor 26 detects the edge of the strip of crystal 15 which is spaced 0.5 mm or less from the side face 27, whereupon the optical fiber sensor 26 outputs a signal to stop and fix the block 25 in position.

If the strip of crystal 15 is transversely or horizontally displaced out of alignment with the vertical central axis of the endless belts 20a, 20b for some reasons, then an edge of the strip of crystal 15 is brought into contact with the side face 27 of the corresponding block 25. Because the side face 27 is fixed in position, the strip of crystal 15 is pulled up while the edge thereof is being held in sliding contact with the side face 27, and hence is prevented from being further displaced.

When the strip of crystal 15 is sandwiched by the endless belts 20a, 20b, the blocks 25 are moved and the distances from the home positions A thereof to the edges of the strip of crystal 15 are measured. Based on the measured distances, it is possible to determine a deviation between the central position intermediate between the blocks 25 in the home positions A and the central position of the strip of crystal 15 while it is being pulled up. The position control device 23 has a function to automatically detect the direction in which a positional displacement of the strip of crystal 15 will occur, and fix the side faces 27 of the blocks 25 to prevent such a positional displacement of the strip of crystal 15. For sufficiently performing the function of the position control device 23, it is necessary to find which position the strip of crystal 15 is in when it is sandwiched by the endless belts 20a, 20b, and correct any positional displacement of the strip of crystal 15 with respect to the direction in which the strip of crystal 15 is pulled up. If the central position of the strip of crystal 15 is detected immediately before the strip of crystal 15 is sandwiched by the endless belts 20a, 20b, then the endless belt pull-up mechanism 20 or the position control device 23 may positionally be adjusted to bring the center thereof into alignment with the center of the strip of crystal 15. Consequently, the strip of crystal 15 can start being continuously pulled up while it is sandwiched between central regions of the endless belts 20a, 20b. Alternatively, after the strip of crystal 15 is sandwiched by the endless belts 20a, 20b, the central position of the endless belts 20a, 20b and the central position of the strip of crystal 15 may be detected, and the home positions of the blocks 25 may be displaced to bring the detected central positions into conformity with each other.

After the central position of the endless belts 20a, 20b is aligned with the central position of the strip of crystal 15, since the width of the strip of crystal 15 varies depending on the length (time) for which the strip of crystal 15 is pulled up, the blocks 25 are periodically moved from their home positions toward the strip of crystal 15. The block 25 which detects the corresponding edge of the strip of crystal 15 at first is stopped, and the other block 25 is returned to the home position thereof. FIGS. 3A and 3B show the blocks 25 thus moved. In FIGS. 3A and 3B, when the strip of crystal 15 as it is pulled up is tilted at an angle θ with respect to the vertical direction, one of the blocks 25 is stopped and fixed in the position B when the sensor 26 thereof detects an edge of the strip of crystal 15, and the other block 25 is returned to its home position A.

FIGS. 4A and 4B show the strip of crystal 15 which has been pulled up from the state shown in FIGS. 3A and 3B, with the edge of the strip of crystal 15 being held in sliding contact with the side face 27 of one of the blocks 25 to correct the strip of crystal 15 from the tilt, thereby allowing the strip of crystal 15 to be pulled up in the normal direction. Specifically, after the strip of crystal 15 has been angularly displaced from the vertical direction, the edge of the strip of crystal 15 is brought into sliding contact with the side face 27 of one of the blocks 25, which restricts the strip of crystal 15 against transverse movement and causes the strip of crystal to be pulled up in the normal direction. In summary, the blocks 25 simultaneously start moving from their home positions A toward the strip of crystal 15, and one of the blocks 25 which detects the corresponding edge of the strip of crystal 15 earlier than the other block 25 is stopped and fixed position, for thereby preventing the strip of crystal 15 from being displaced and correcting the strip of crystal 15 from any tilt from the normal direction in which it is pulled up.

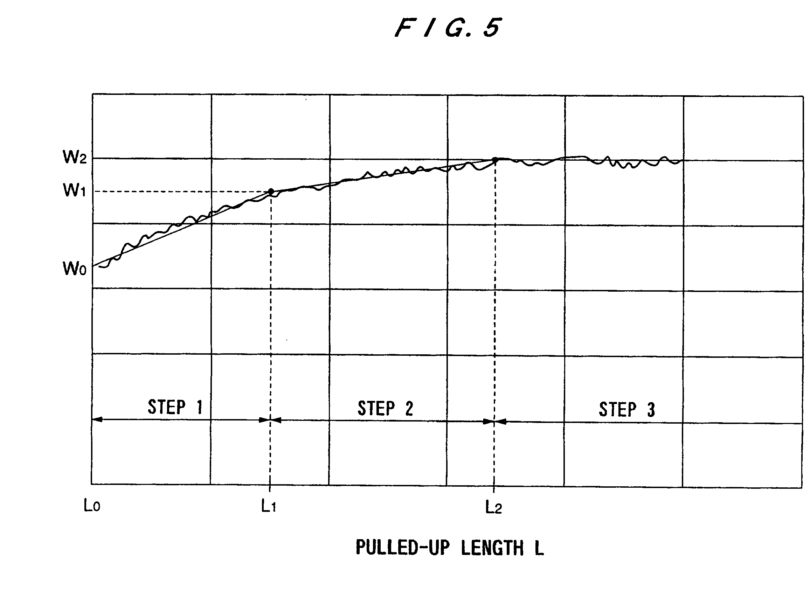

FIG. 5 shows how a crystal being pulled up spreads transversely. As described above, when a linear seed crystal is pulled up by the vertical straight pull-up mechanism, a dendritic crystal grows on each side of the linear seed crystal, and a strip or web of crystal begins to grow between the dendritic crystals. The strip of crystal is pulled up for a certain length, whereupon the seed crystal is cut off, and the strip of crystal is transferred to the endless belt pull-up mechanism. If the strip of crystal immediately after it is transferred to the endless belt pull-up mechanism has a width $W_0$ ranging from 40 to 50 mm, for example, then the width of the strip of crystal subsequently increases with time until it reaches a constant width $W_2$ ranging from 70 to 80 mm, for example, in a steady state. The vertical axis of the graph shown in FIG. 5 represents the width of the strip of crystal, and the horizontal axis the length for which the strip of crystal is pulled up. Since the speed at which the strip of crystal is pulled up is substantially constant, the length for which the strip of crystal is pulled up, or the pulled-up length, which is represented by the horizontal axis of the graph shown in FIG. 5 is proportional to time.

As shown in FIG. 5, in a step 1 where the pulled-up length increases from $L_0$ to $L_1$, the width of the strip of crystal increases at a relatively large speed. In the step 1, therefore, it is necessary to return the blocks to their home positions, detect a next edge of the strip of crystal, and fix the blocks in position relatively frequently. The period at which the position of the blocks is set in the step 1 is represented by the following equation (1):

$$T_1 = 21/(W_1 - W_0)/(L_1 - L_0) \qquad (1)$$

where l indicates the distance between an edge of the strip of crystal and the side edge of the corresponding block when the sensor detects the edge of the strip of crystal (see FIG. 3A). When the pulled-up length reaches $L_1$, the repetitive cycle enters a next step 2.

In the step 2, the width of the strip of crystal increases at a relatively small speed. The period at which the position of the blocks is set in the step 2 is represented by the following equation (2):

$$T_1 = 21/(W_2 - W_1)/(L_2 - L_1) \qquad (2)$$

In a step 3 following the step 2, the width of the strip of crystal does not increase essentially, and the blocks remain fixed in position.

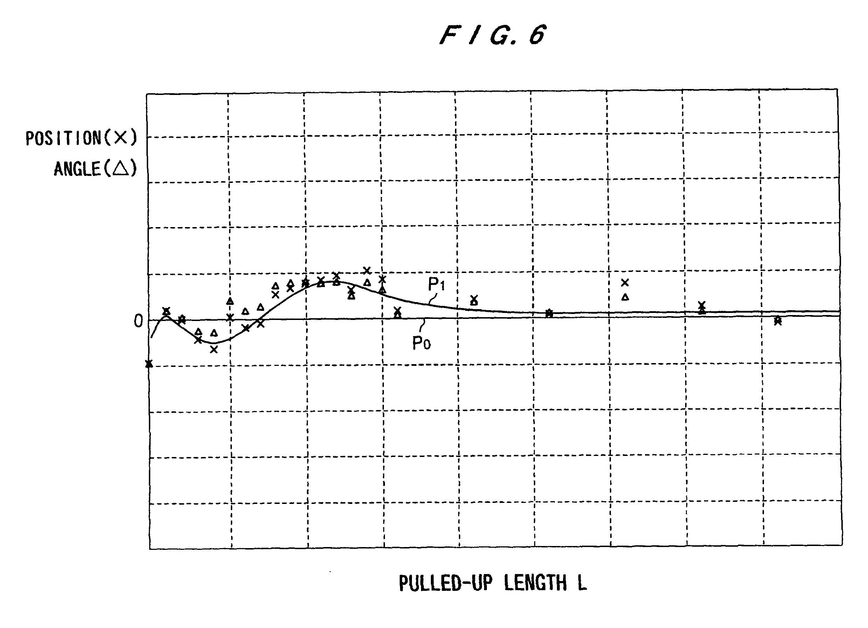

FIG. 6 shows measured central positions of a crystal and measured angles at which the crystal is tilted, when the crystal is positionally controlled by the blocks of the position control device. The horizontal axis of the graph shown in FIG. 6 represents the pulled-up length of the strip of crystal, and the vertical axis thereof the central position of the strip of crystal. In FIG. 6, "x" indicates measured central positions of the strip of crystal, and "Δ" measured angles at which the strip of crystal is tilted. A curve $P_0$ represents the central axis of the endless belts, indicating that it is angularly aligned with the center of the strip of crystal, i.e., any angular displacement between the central axis of the endless belts and the center of the strip of crystal is 0°. A curve $P_1$ represents the tendency of the measured data of the strip of crystal. The curve $P_1$ reveals that while the center of the strip of crystal is slightly displaced out of alignment with the central axis of the endless belts in an initial phase, it is subsequently corrected into a constant position.

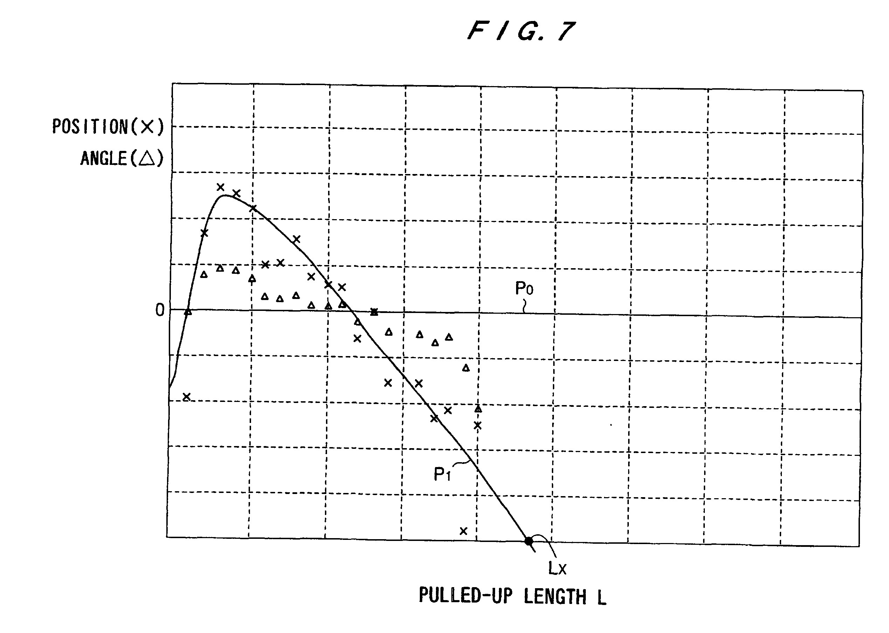

FIG. 7 shows measured central positions of a crystal and measured angles at which the crystal is tilted, when the crystal is not positionally controlled by the blocks of the position control device. In FIG. 7, "x" indicates measured central positions of the strip of crystal, and "Δ" measured angles at which the strip of crystal is tilted. The measured central positions "x" displaced from the central axis 0 of the endless belts indicate the central position of the strip of crystal which is displaced from the central axis of the central belts, and the measured angles "Δ" indicate the direction of growth of the strip of crystal which is angularly displaced from the central axis of the central belts. A curve $P_1$ representing the measured central positions of the strip of crystal and the measured angles at which the strip of crystal is tilted greatly varies from a curve $P_0$ and indicates that the central position of the strip of crystal is displaced off the endless belts at a pulled-up length Lx.

According to the conventional process of pulling up the strip of crystal with the endless belts, the strip of crystal tends to be displaced away from the central axis of the endless belts and off the endless belts while the strip of crystal is being pulled up. The position control device according to the present invention is effective to restrict the direction of growth of the strip of crystal with the side faces of the blocks, prevent the center of the strip of crystal from being displaced from the central axis of the endless belts, and allow the strip of crystal to be continuously pulled up. As described above, the width of the strip of crystal gradually increases into a constant width from the start of the pulling up of the strip of crystal. While the width of the strip of crystal varies until it reaches the constant width, the blocks are returned to their home positions and positionally set in periodic cycles whose period corresponds to the speed at which the width of the strip of crystal increases. Therefore, the strip of crystal can be pulled up stably at all times.

According to the present invention, the position control device for automatically adjusting the transverse position of a strip of crystal is disposed on a path along which the strip of crystal is pulled up. The position control device allows endless belts to pull up the strip of crystal stably without the need for manual adjustments and operations. Consequently, the conventional skill-demanding and complex process of adjusting the position of the strip of crystal is no longer required to be carried out, and the strip of crystal of stable quality can be mass-produced stably.

Although a certain preferred embodiment of the present invention has been shown and described in detail, it should be understood that various changes and modifications may be made therein without departing from the scope of the appended claims.

**Claims**

1. An apparatus for pulling up a strip of semiconductor crystal continuously from a crucible (12), comprising:

a crystal growth furnace (11) having a crucible (12);
a pair of endless belts (20a, 20b) for continuously pulling up a strip of semiconductor crystal (15) from said crucible (12); said apparatus, comprising:
a position control device (23) for automatically adjusting a transverse position of the strip of semiconductor crystal (15), said position control device (23) being disposed in a path for pulling up the strip of semiconductor crystal (15) from the crucible (12), wherein said position control device (23) comprises:
a pair of blocks (25) disposed on each side of said path, said blocks (25) having side faces (27) for adjusting a direction of the strip of semiconductor crystal (15) by contacting an edge of the strip, said blocks (25) being periodically moved from their home positions (A) toward the strip of crystal (15); and
a pair of position sensors (26) mounted respectively on said blocks (25) for detecting an edge of the strip and fixing the transverse position of said block.

2. An apparatus according to claim 1, further comprising:

a control mechanism for simultaneously starting to move said blocks (25) from respective home positions (A) thereof, and stopping said blocks against movement when the position sensor (26) on either one of said blocks (25) detects a corresponding edge of the strip of semiconductor crystal (15).

3. An apparatus according to claim 2, wherein said position control device (23) is disposed below the pair of endless belts (20a, 20b).

4. An apparatus according to claim 1, wherein said position control device (23) has a function to return said blocks (25) to their home positions (A) at a time interval.

5. A method of pulling up a strip of semiconductor crystal (15) continuously, comprising:

disposing a pair of movable blocks (25) on each side of the strip (15);
detecting an edge of the strip of semiconductor crystal (15) when the blocks (25) are moving inwardly from their home position (A) while the strip of semiconductor crystal (15) is being pulled up; and
fixing a side face (27) near the detected edge for sliding contact with the detected edge so as to restrict the strip of semiconductor crystal (15) against transverse movement.

6. A method according to claim 5, wherein the edge of the strip of semiconductor crystal is detected and the side face (27) is positionally adjusted intermittently depending on a change in the transverse dimension of the strip of semiconductor crystal (15).

**Patentansprüche**

1. Vorrichtung zum kontinuierlichen Herausziehen eines Streifens eines Halbleiterkristalls aus einem Tiegel (12), die Folgendes aufweist:

einen Kristallwachstumsofen (11) mit einem Tiegel (12);
ein paar von Endlosbändern (20a, 20b) zum kontinuierlichen Herausziehen eines Streifens aus Halbleiterkristall (15) aus dem Tiegel (12), wobei die Vorrichtung Folgendes aufweist:

eine Positionssteuervorrichtung (23) zum automatischen Einstellen einer Quer- bzw. Seitenposition des Streifens aus Halbleiterkristall (15), wobei die Positionssteuervorrichtung (23) in einem Pfad zum Herausziehen des Streifens aus Halbleiterkristall (15) aus dem Tiegel (12) angeordnet ist, wobei die Positionssteuervorrichtung (23) Folgendes aufweist:

ein Paar von Blöcken (25), die auf jeder Seite des Pfades angeordnet sind, wobei die Blöcke (25) Seitenflächen (27) aufweisen zum Einstellen einer Richtung des Streifens des Halbleiterkristalls (15) durch Kontaktieren einer Kante des Streifens, wobei die Blöcke (25) periodisch aus ihren Ruhepositionen (A) zu dem Streifen aus Kristall (15) bewegt werden; und
ein Paar von Positionssensoren (26), die jeweils an den Blöcken (25) angebracht sind zum Detektieren einer Kante des Streifens und zum Festlegen der Quer- bzw. Seitenposition des Blocks.

2. Vorrichtung nach Anspruch 1, die ferner Folgendes aufweist:

einen Steuermechanismus zum simultanen Starten einer Bewegung der Blöcke (25) aus ihren jeweiligen Ruhepositionen (A) und zum Anhalten der Blöcke, wenn der Positionssensor (26) an einem der Blöcke (25) eine entsprechende Kante des Streifens aus Halbleiterkristall (15) detektiert.

**3.** Vorrichtung nach Anspruch 2, wobei die Positionssteuervorrichtung (23) unterhalb des Paars von Endlosbändern (20a, 20b) angeordnet ist.

**4.** Vorrichtung nach Anspruch 1, wobei die Positionssteuervorrichtung (23) einer Funktion zum Zurückführen der Blöcke (25) zu ihren Ruhepositionen (A) an einem Zeitintervall besitzt.

**5.** Verfahren zum kontinuierlichen Hochziehen eines Streifens aus Halbleiterkristall (15), das Folgendes aufweist:

Anordnen eines Paars von bewegbaren Blökken (25) an jeder Seite des Streifens (15); Detektieren einer Kante des Streifens aus Halbleiterkristall (15), wenn sich die Blöcke (25) nach innen aus ihren Ruhepositionen (A) bewegen, während der Streifen aus Halbleiterkristall (15) hochgezogen wird; und Fixieren einer Seitenfläche (27) in der Nähe der detektierten Kante für einen Gleitkontakt mit der detektierten Kante um den Streifen aus Halbleiterkristall (15) gegenüber einer Querbzw. Seitenbewegung einzuschränken.

**6.** Verfahren nach Anspruch 5, wobei die Kante des Streifens aus Halbleiterkristall (15) detektiert wird und die Seitenfläche (27) in ihrer Position periodisch eingestellt wird, und zwar in Abhängigkeit von einer Veränderung in der Quer- bzw. Seitenabmessung des Streifens des Halbleiterkristalls (15).

**Revendications**

**1.** Appareil pour le tirage continu d'une bande d'un cristal semiconducteur à partir d'un creuset (12), comprenant :

un four (11) de croissance du cristal comportant un creuset (12); une paire de courroies sans fin (20a,20b) pour tirer continûment une bande de cristal semiconducteur (15) à partir dudit creuset (12); ledit appareil comprenant :

un dispositif de commande de position (23) pour ajuster automatiquement une position transversale de la bande de cristal semiconducteur (15), ledit dispositif de commande de position (23) étant disposé dans un trajet servant à tirer la bande de cristal semiconducteur (15) à partir du creuset (12), dans lequel ledit dispositif de commande de position (23) comprend :

une paire de blocs (25) disposés de chaque côté dudit trajet, lesdits blocs (25) possédant des faces latérales (27) pour ajuster une direction de la bande de cristal semiconducteur (15) par établissement d'un contact avec un bord de la bande, lesdits blocs (25) étant déplacés périodiquement à partir de leurs positions de repos (A) en direction de la bande de cristal (15); une paire de capteurs de position (26) montés respectivement sur lesdits blocs (25) pour détecter un bord de la bande et fixer la position transversale dudit bloc.

**2.** Dispositif selon la revendication 1, comprenant en outre :

un mécanisme de commande pour commencer simultanément à déplacer lesdits blocs (25) à partir de leurs positions respectives de repos (A), et empêcher un déplacement desdits blocs lorsque le capteur de position (26) sur chacun desdits blocs (25) détecte un bord correspondant de la bande de cristal semiconducteur (15).

**3.** Dispositif selon la revendication 2, dans lequel ledit dispositif de commande de position (23) est disposé au-dessous de la paire de courroies sans fin (20a, 20b).

**4.** Dispositif selon la revendication 1, dans lequel ledit dispositif de commande de position (23) a pour fonction de ramener lesdits blocs (25) dans leur position de repos (A) au bout d'un certain intervalle de temps.

**5.** Procédé de tirage continu d'une bande de cristal semiconducteur (15) consistant à :

disposer une paire de blocs mobiles (25) de chaque côté de la bande (15); détecter un bord de la bande de cristal semiconducteurs (15) lorsque les blocs (25) se déplacent vers l'intérieur à partir de leur position de repos (A), au cours du tirage de la bande de cristal semiconducteur (15); et fixer une face latérale (27) à proximité du bord détecté pour un contact coulissant avec le bord détecté de manière à limiter la bande du cristal semiconducteur (15) à l'encontre d'un déplacement transversal.

**6.** Procédé selon la revendication 5, dans lequel le bord de la bande de cristal semiconducteur est détecté et la face latérale (23) est ajustée en position de manière intermittente en fonction d'une variation de la dimension transversale de la bande du cristal semiconducteur (15).

# FIG. 1A

# FIG. 1B

FIG. 2A

FIG. 2B

# F I G. 3 A

# F I G. 3 B

# F I G. 4 A

# F I G. 4 B

# F I G. 5

PULLED-UP LENGTH L

EP 1 241 282 B1

# F I G. 6

POSITION(×)
ANGLE(△)

0

P₁

P₀

PULLED-UP LENGTH L

EP 1 241 282 B1

# F I G. 7

POSITION(×)
ANGLE(△)

0

P₀

P₁

Lx

PULLED-UP LENGTH L